# EUROPEAN PATENT APPLICATION

(11) **EP 0 613 174 A2**
(43) Date of publication of application: **31.08.1994**
(21) Application number: 94301125.4
(22) Date of filing: 16.02.1994
(51) Int. Cl.: H01L 21/033, H01L 21/28, H01L 21/027, H01L 21/338

(54) **Method for making fine-line semiconductor devices**

(30) Priority: 26.02.1993 US 23547
(71) Applicant: AT&T Corp., New York, NY 10013-2412 (US)
(72) Inventor: Abernathy, Cammy Renee, Scotch Plains, New Jersey 07076 (US); Lothian, James Robert, Bethlehem, Pennsylvania 18018 (US); Pearton, Stephen John, Summit, New Jersey 07901 (US); Ren, Fan, Warren, New Jersey 07059 (US)
(74) Representative: Watts, Christopher Malcolm Kelway, Dr.

(57) **Abstract**

In accordance with the invention a fine-line semiconductor device is fabricated by the steps of applying a layer of resist (11) to the surface of a semiconductor substrate (10), opening a line in the resist with negative sloping side walls, applying to the patterned structure a layer of material (16) which conforms to both horizontal and vertical surfaces including the negative sloping sidewalls, thereby reducing the width of the opened line; and etching away the horizontal portions of the conforming layer using the overhanging portion of the conforming layer as a mask. The result is an exposed line of semiconductor (19) having a width reduced from the original width by more than twice the thickness of the conforming layer. The invention is illustrated by the fabrication of a gallium arsenide MESFET transistor with a 0.4 micron gate length. Gate lengths so small as 0.1 micron have been made using this technique.

## Description

### Field of the Invention

This invention relates to methods for fabricating fine-line semiconductor devices such as field effect transistors having submicron gate width. An improved transistor is also described.

### Background of the Invention

The goal of reducing minimum line widths in semiconductor device fabrication is well known. Finer lines in field effect transistors mean shorter gate widths, reduced carrier transit times, reduced propagation delays and higher operating frequencies. Considerable efforts have been expended to reduce minimum line widths below one micron. Technology developed to push the state of the art includes deep ultraviolet optical lithography, x-ray lithography and phase shift masking techniques. Each new reduction in linewidth has been obtained only by the use of increasingly expensive and elaborate technology. Moreover the currently preferred approach of electron beam lithography is slow. Accordingly, there is a need for a quick, inexpensive method for fabricating fine-line semiconductor devices.

### Summary of the Invention

A fine-line semiconductor device is fabricated by the steps of applying a layer of resist to the surface of a semiconductor substrate, opening a line in the resist with negative sloping side walls, applying to the patterned structure a layer of material which conforms to both horizontal and vertical surfaces including the negative sloping sidewalls, thereby reducing the width of the opened line; and etching away the horizontal portions of the conforming layer using the overhanging portion of the conforming layer as a mask. The result is an exposed line of semiconductor having a width reduced from the original width by more than twice the thickness of the conforming layer. The invention is illustrated by the fabrication of a gallium arsenide MESFET transistor with a 0.4 micron gate length. Gate lengths so small as 0.1 micron have been made using this technique.

### Brief Description of the Drawings

In the drawings:
FIG. 1 is a block diagram illustrating the steps of the process for making a fine-line semiconductor device;
FIGs. 2-5 illustrate schematic cross sections of a workpiece at various steps in the fabrication process of FIG. 1;
FIG. 6 is a schematic cross section of a workpiece for making a MESFET; and
FIG. 7 is a schematic cross section of a MESFET having a fine-line gate electrode fabricated in accordance with the method of FIG. 1.

### Detailed Description

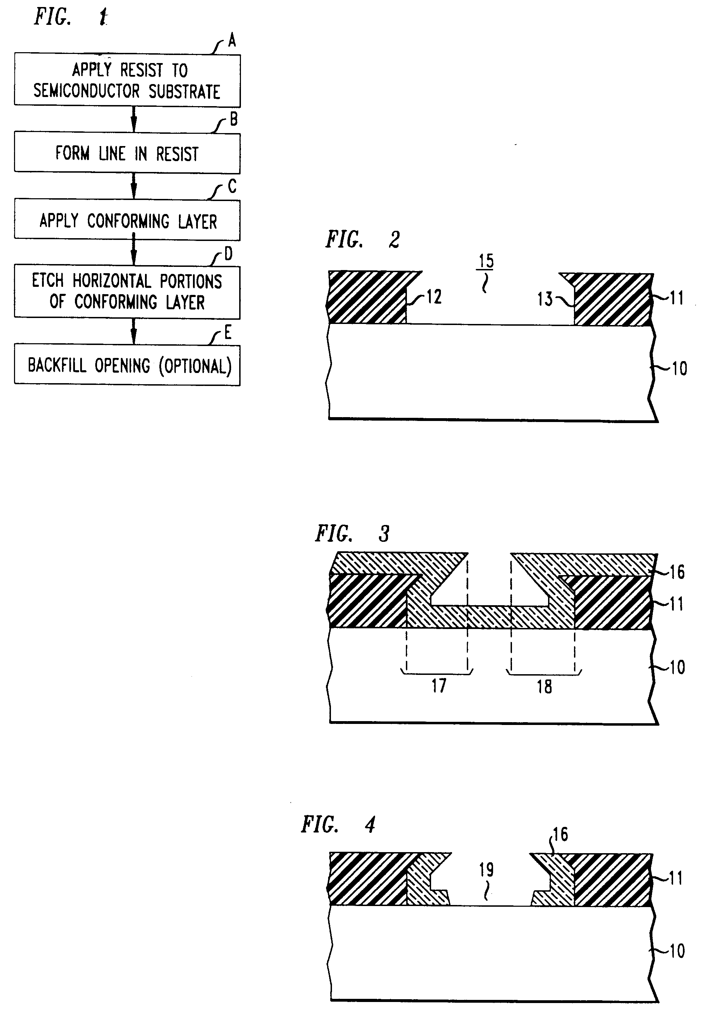

Referring to the drawings, FIG. 1 is a block diagram showing the steps of a preferred process for making fine-line semiconductor devices. As shown in block A, the first step is to apply to a semiconductor substrate a layer of resist in which lines of two microns or less can be opened, as by conventional photolithographic processes. For example, the substrate can be a 3 inch semi-insulating (100) GaAs substrate marketed by American Xtal Technology bearing a 1-2 micron thick layer of Hoehst 5209E positive resist. The resist can be applied by conventional spin deposition techniques.

The second step, shown in block B of FIG. 1, is to open in the resist a line having negative sloping sidewalls. Specifically, this step involves opening a line having a width of two micrometers or less. This opening can be accomplished with conventional optical lithography, as by exposing the resist in an Ultratech 1X stepper and developing away the exposed resist. The line is formed in such a fashion that the sidewalls have a negative profile (i.e. the sidewalls are concave in cross section and overhang the exposed semiconductor). A negative profile can be assured by the chlorobenzene soaking technique described by M. Hatzakis et al., 24 IBM J. Rev. Dev. 452 (1980), or by offsetting the focus for stepper printing.

FIG. 2 is a schematic cross section of the resulting structure showing the substrate 10, the resist layer 11, and the negative profile sidewalls 12 and 13 defining a line opening 15.

The next step shown in FIG. 1, block C, is applying to the structure of FIG. 2 a layer of conforming material which conforms to both horizontal and vertical surfaces including the negative sloping sidewalls, thereby reducing the width of the line opening. This application is preferably accomplished by plasma enhanced chemical vapor deposition (PECVD) of silicon nitride SiNₓ at low temperature (about 50°C). Low temperature is needed to avoid distorting the resist pattern. Preferably the conforming layer has a thickness of less than two micrometers. Low temperature deposited SiNx exhibits excellent step coverage and uniformity of thickness.

As shown in FIG. 3, the line width is reduced by more than twice the thickness of the conforming layer 16. The conformation of the SiNₓ layer with the negative vertical profile of the resist produces masking regions 17 and 18 overhanging the edges of the line to be formed.

The fourth step in FIG. 1, block D, is etching away horizontal portions of the conforming layer to open up a fine-line exposure of the underlying semiconductor. In the instance of an SiNₓ conformable layer, this etching is preferably effected by an SF₆-based plasma back etching process. The back etching can be done in a Plasma Therm electron-cyclotron resonance etching system at a 1 m Torr pressure and a self-bias of - 75V. The etching is carried out for a length of time sufficient to remove unprotected horizontal portions of the conformable layer on the semiconductor.

The results of the back etching process are shown in FIG. 4. As can be seen, portions of the conformable layer within opening 15 are masked both by the vertical portions of the conformable layer and by the overhanging masking regions 17 and 18. The result is a new opening 19 exposing the underlying semiconductor along a line substantially narrower than the original opening 15. If opening 15 has an initial width of about one micrometer, opening 19 can be made as small as 0.1 micrometer. Concurrently opening 15 will become wider due to anisotropic etching of the narrow conforming layer at the edges of the opening. This preferential etching produces an opening 19 having a characteristic and highly advantageous "V"-shape.

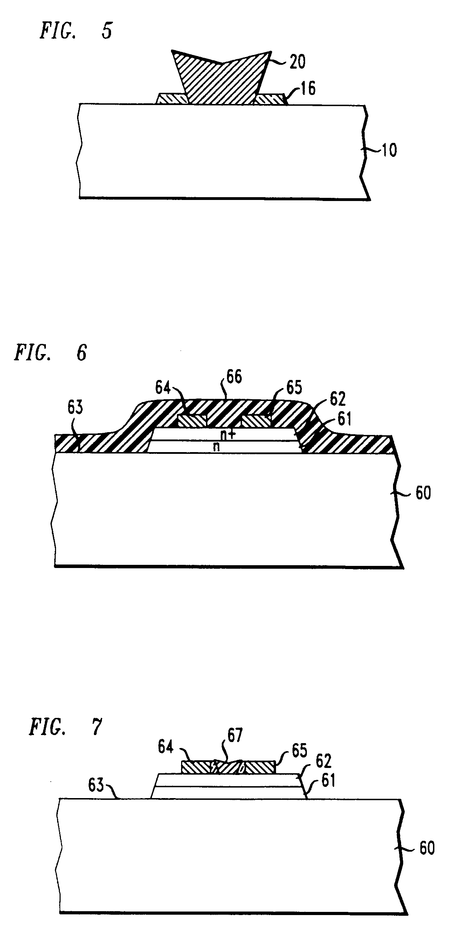

The next step in block E, which is optional in some applications, is to backfill opening 19 with material. For example, the opening 19 can be filled with evaporated metal to form a contact with the exposed semiconductor. Advantageously, as shown in FIG. 5 the resist 11 and portions of the backfilled metal layer are removed in a conventional lift-off process leaving a Y-shaped, fine-line metal contact 20.

The method and utility of the invention can be understood in greater detail by consideration of the following specific example of fabrication of a MESFET transistor. The first step is to form a suitably processed semiconductor substrate to which the process of FIG. 1 can be applied. FIG. 6 is an example of a suitable GaAs substrate 60 having on an outer surface n and n⁺ regions 61, 62 peripherally surrounded by isolation region 63. A pair of separated ohmic contacts 64 and 65, such as AuGe alloy are spaced a few micrometers apart to function as source and drain electrodes in the finished transistor. In accordance with step 1 of the FIG. 1 process, a thin layer of resist 66 has been applied to the outer surface.

The structure of FIG. 6 can be fabricated in accordance with techniques well known in the art. In an exemplary embodiment, the n layer 61 is implantation doped with silicon to a concentration of 10¹⁷cm⁻³ and the n⁺ layer is doped to 3x10¹⁸ cm⁻³. The isolation region 63 is formed by ion milling, and the ohmic contacts are deposited by electron beam evaporation. The distance between adjacent edges of contacts 64 and 65 can be about 5 micrometers.

The process of FIG. 1 is applied to this substrate to expose a fine line opening to the gallium arsenide approximately centered between contacts 64 and 65. The opening is conveniently about 0.4 micrometers in width. The opening is backfilled with a composite metal layer of Ti/Pt/Au deposited by E-beam evaporation to form a Schottky gate for the MESFET. Excess metal is removed by the lift-off process.

FIG. 7 is a schematic cross section of the transistor structure after the process of FIG. 1 (but before final metallization) showing the source 64, the drain 65, and the intervening gate 67. If formed by the lift-off process, the gate 67 has a characteristic Y-shaped cross section which permits good electrical contact to lead metallization (not shown).

The electrical characteristics of 0.4 micrometer gate length GaAs MESFETs fabricated in accordance with this process are comparable to the performance of submicron MESFETs made using electron-beam fabrication techniques.

## Claims

1. A method for making fine line semiconductor devices comprising the steps of:
applying a layer of resist to a semiconductor substrate;
forming a first line in said layer of resist having negative profile sidewalls to expose the underlying substrate;
applying a conforming layer of material over the region of the substrate including the negative sidewalls; and
etching away portions of said conforming layer in order to expose said semiconductor substrate in a line opening narrower than said first line.

2. The method according to claim 1, wherein said conforming layer comprises silicon nitride.

3. The method according to claim 1, further comprising the step of backfilling said narrower line opening with metal.

4. The method according to claim 2, wherein said conforming layer is applied by plasma enhanced chemical vapor deposition.

5. A method for fabricating a field effect semiconductor device comprising the steps of:
providing a semiconductor substrate having spaced apart ohmic contacts;
applying a layer of resist overlying the region between the contacts;
forming a first line in said layer of resist having negative profile sidewalls to expose the underlying substrate;
applying a conforming layer of material over the region of the substrate including the negative sidewalls;
etching away portions of said conforming layer in order to expose said semiconductor substrate in a line opening narrower than said first line; and
backfilling said narrower line opening with metal to form a Schottky contact with the semiconductor.

6. The method of claim 5, wherein said semiconductor substrate comprises gallium arsenide and said conforming layer comprises silicon nitride.

7. The method of claim 5, further comprising the step of removing excess metal.

8. The method of claim 5, wherein said narrower line opening has a width of less than a micrometer.
